# EUROPEAN PATENT APPLICATION

(11) **EP 4 730 961 A1**
(43) Date of publication of application: **22.04.2026**
(21) Application number: 25181337.4
(22) Date of filing: 06.06.2025
(51) Int. Cl.: H10F 19/80, H10F 71/00, B32B 37/00

(54) **SOLAR CELL MODULE PRESS APPARATUS**

(30) Priority: 21.10.2024 KR 20240144345
(71) Applicant: Hanwha Solutions Corporation, Jung-gu Seoul 04541 (KR)
(72) Inventor: MOON, Il Sik, Seoul 04541 (KR); HWANG, Sang Jun, Seoul 04541 (KR); KIM, Sang Ho, Seoul 04541 (KR); YANG, Seong Won, Seoul 04541 (KR); KIM, Hae Kun, Seoul 04541 (KR); PARK, Sung Chan, Seoul 04541 (KR); CHOI, Jin Uk, Seoul 04541 (KR)
(74) Representative: Mooser, Sebastian Thomas

(57) **Abstract**

A disclosed solar cell module press apparatus includes a first plate configured to be brought into contact with one side of a solar cell module to support the solar cell module, a second plate configured to be brought into contact with the other side of the solar cell module and move toward the first plate to press the solar cell module, a first cylinder actuator configured to move the second plate toward the first plate until the second plate is brought into contact with the solar cell module, and a second cylinder actuator configured to press the second plate toward the first plate so that the solar cell module is pressed after the second plate is brought into contact with the solar cell module.

## Description

### BACKGROUND

### 1. Field of the Invention

The present invention relates to a solar cell module press apparatus for pressing and coupling a solar cell module.

### 2. Discussion of Related Art

A solar cell module includes a solar cell that converts light energy into electric energy using a photoelectric effect, and a first substrate and a second substrate that cover one side and the other side of the solar cell.

A solar cell module is pre-assembled with adhesive sheets interposed between the first substrate and the solar cell and between the second substrate and the solar cell, and the pre-assembled solar cell module is pressed by a solar cell module press apparatus, ensuring that the first and second substrates are adhered to the solar cell via the adhesive sheets, resulting in a final solar cell module.

### SUMMARY OF THE INVENTION

The present invention is directed to providing a solar cell module press apparatus that presses a solar cell module over an entire area of the solar cell module with uniform pressure.

According to an aspect of the present invention, there is provided a solar cell module press apparatus including a first plate configured to be brought into contact with one side of a solar cell module to support the solar cell module, a second plate configured to be brought into contact with the other side of the solar cell module and move toward the first plate to press the solar cell module, a first cylinder actuator configured to move the second plate toward the first plate until the second plate is brought into contact with the solar cell module, and a second cylinder actuator configured to press the second plate toward the first plate so that the solar cell module is pressed after the second plate is brought into contact with the solar cell module.

The solar cell module press apparatus may further include a first chamber configured to support the first plate, and a second chamber configured to support the second plate, the first cylinder actuator, and the second cylinder actuator, and move into close contact with the first chamber and away from the first chamber, wherein, when the second chamber is brought into close contact with the first chamber, an internal space accommodating the first plate and the second plate may be defined.

The first chamber may include a first base part, and a first side wall part protruding from the first base part toward the second chamber, the second chamber may include a second base part, and a second side wall part protruding from the second base part toward the first chamber, and when the second side wall part is brought into close contact with the first side wall part, the second chamber may be brought into close contact with the first chamber.

The first plate may include a first body, and a first friction mitigation film configured to cover one side of the first body facing the solar cell module to reduce friction when the first plate is brought into contact with the solar cell module.

The second plate may further include a second body, and a second friction mitigation film configured to cover one side of the second body facing the solar cell module to reduce friction when the second plate is brought into contact with the solar cell module.

The second plate may further include an elastic pad overlapping the solar cell module between the one side of the second body and the second friction mitigation film.

The elastic pad may include silicone rubber.

The second friction mitigation film may include a recessed seating groove for seating the elastic pad.

The second friction mitigation film may be supported by the second chamber.

The friction mitigation film may include polytetrafluoroethylene (PTFE).

The second plate may include a collision plate that is positioned to be aligned with the second cylinder actuator and with which the second cylinder actuator collides when the second cylinder actuator presses the second plate toward the first plate.

The solar cell module press apparatus may further include a vacuum pump configured to discharge air from the internal space to the outside of the first chamber and the second chamber so that a vacuum pressure is formed in the internal space.

The first chamber may include a first base part, and a first side wall part protruding from the first base part toward the second chamber, the second chamber may include a second base part, and a second side wall part protruding from the second base part toward the first chamber, the internal space may include a first space defined by the first base part and the first side wall part, and a second space defined by the second base part and the second side wall part, and The solar cell module press apparatus may further include an air flow line configured to connect the first space to the second space to enable air flow.

At least one of the first plate and the second plate may include a heater configured to heat the solar cell module.

A pressing force of the second cylinder actuator may not be applied to the second plate until the second plate is brought into contact with the solar cell module, and a pressing force of the first cylinder actuator may not be applied to the second plate after the second plate is brought into contact with the solar cell module.

The first cylinder actuator may include a first cylinder body fixed to the second chamber, one end inserted into the first cylinder body, a flange part located outside the first cylinder body, and a neck part connecting the one end to the flange part and having a diameter smaller than the flange part, and the second plate may include a second body, and a cylinder rod holder fixed to the second body and having a flange part space formed therein, the flange part being inserted into the flange part space.

The cylinder rod holder may include a stopper part configured to block the flange part to prevent the flange part from coming off from the flange part space, and the flange part space may have a clearance that allows the flange part to move parallel to a longitudinal direction of the first cylinder rod.

The second cylinder actuator may include a second cylinder body fixed to the second chamber, and a second cylinder rod including one end inserted into the second cylinder body, and another end configured to protrude to the outside of the second cylinder body, come into close contact with the second plate in a state in which the other end is separated from the second plate, and push the second plate away from the second cylinder body.

The first cylinder actuator may operate according to pneumatic pressure and the second cylinder actuator may operate according to hydraulic pressure.

The solar cell module press apparatus may further include a pressure sensor configured to measure a level of the hydraulic pressure supplied to the second cylinder actuator, and a regulator configured to adjust the hydraulic pressure supplied to the second cylinder actuator based on the level of the hydraulic pressure measured by the pressure sensor.

A distance from a center of a planar shape of the second plate to the second cylinder actuator may be smaller than a distance from the center of the planar shape of the second plate to the first cylinder actuator.

The solar cell module may include a first substrate in contact with the first plate, a second substrate in contact with the second plate, a solar cell interposed between the first substrate and the second substrate, a first adhesive sheet interposed between the first substrate and the solar cell, and a second adhesive sheet interposed between the second substrate and the solar cell, and the second cylinder actuator may press the second plate so that thicknesses of the first adhesive sheet and the second adhesive sheet are reduced, the first adhesive sheet may be adhered to the first substrate and the solar cell, and the second adhesive sheet may be adhered to the second substrate and the solar cell.

### BRIEF DESCRIPTION OF THE DRAWINGS

The above and other objects, features and advantages of the present invention will become more apparent to those of ordinary skill in the art by describing exemplary embodiments thereof in detail with reference to the accompanying drawings, in which:
FIG. 1 is a configuration diagram of a solar cell module press apparatus according to an embodiment of the present invention;
FIG. 2 is an enlarged view of part A of FIG. 1;
FIG. 3 is a plan view of an upper plate in FIG. 1;
FIG. 4 is a cross-sectional view of a solar cell module that is not yet loaded onto the solar cell module press apparatus in FIG. 1;
FIG. 5 is a cross-sectional view of the solar cell module pressed by the solar cell module press apparatus in FIG. 1;
FIG. 6 is a cross-sectional view illustrating a lower plate in FIG. 1 and the solar cell module loaded onto the lower plate;
FIG. 7 is a cross-sectional view illustrating the solar cell module press apparatus in FIG. 1 and the solar cell module pressed by the solar cell module press apparatus;
FIG. 8 is an enlarged view of part B of FIG. 7; and
FIG. 9 is an enlarged view of part C of FIG. 7.

### DETAILED DESCRIPTION OF EXEMPLARY EMBODIMENTS

Hereinafter, a solar cell module press apparatus according to the present invention will be described with reference to the accompanying drawings. In this case, thicknesses of lines or sizes of components shown in the drawings may be exaggerated for the sake of clarity and convenience of description. Further, terms to be described below are defined in consideration of their functions in the present invention, and may vary depending on the intention or convention of a user or operator. Therefore, these terms should be defined based on the content throughout the present specification.

Further, when it is said in the present specification that a part is "connected (or coupled)" to another part, this includes not only a case in which the part is "directly connected (or coupled)" to the other part but also a case in which the part is "indirectly connected (or coupled)" to the other part with another member in between. In the present specification, when a part is said to "include (or comprise)" a certain component, this does not mean that the part excludes other components unless otherwise specifically stated, but that the part may further "include (or comprise)" other components.

Further, a component described as a "unit," "module" or "part" in the present specification performs at least one function or operation. A "unit," "module" or "part" may perform the function or operation by hardware, software or a combination of hardware and software. Further, a plurality of "units," a plurality of "modules," or a plurality of "parts" other than the "unit," "module" or "part" that should be performed in specific hardware or is performed in at least one processor may be integrated into at least one module. A singular expression includes a plural expression unless the context clearly indicates otherwise.

Further, the same reference signs throughout the present specification may refer to the same components. Even when the same reference signs or similar reference signs are not mentioned or described in a specific drawing, the reference signs may be described based on other drawings. Further, even when a part is not denoted by a reference sign in a specific drawing, the part may be described based on other drawings. Further, the number, shape, size, relative difference in size, and the like of detailed components included in the drawings of the present application are set for convenience of understanding, do not limit the embodiments, and may be implemented in various forms.

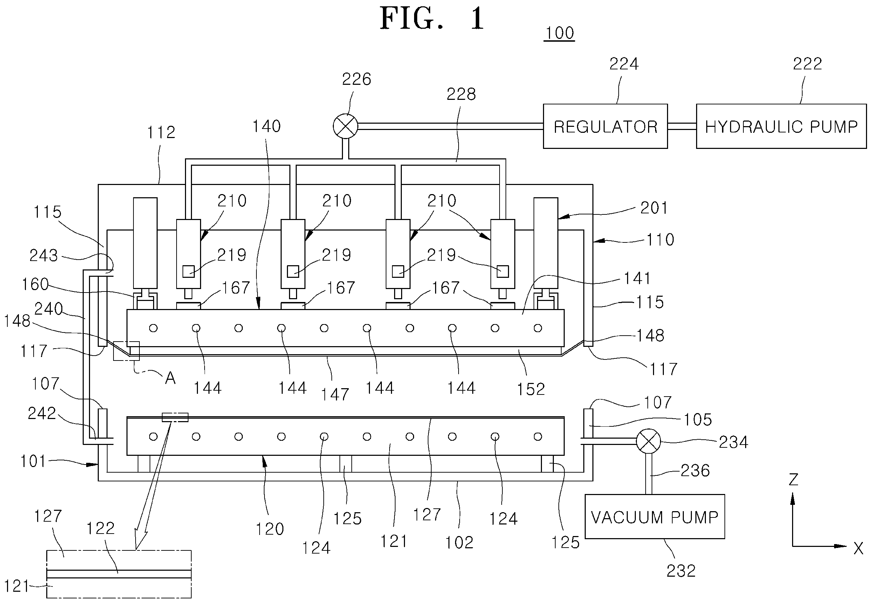

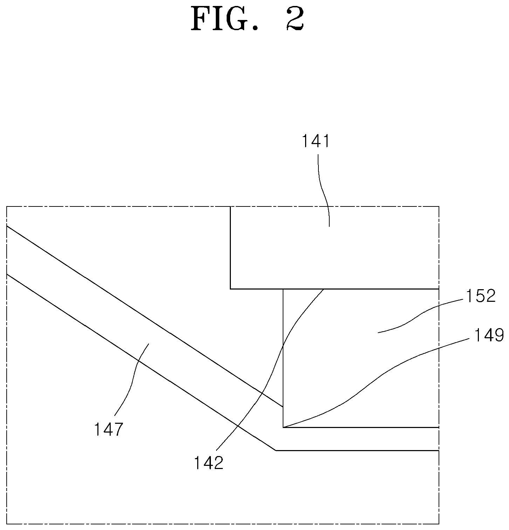

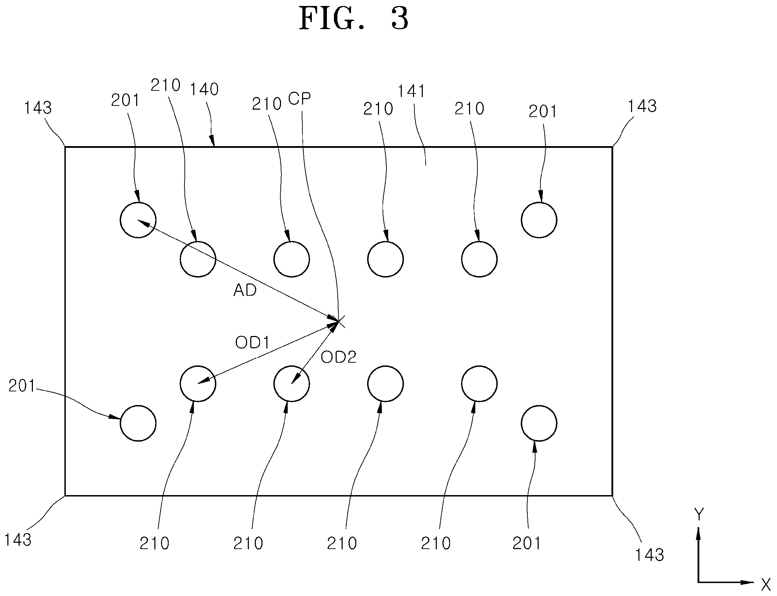

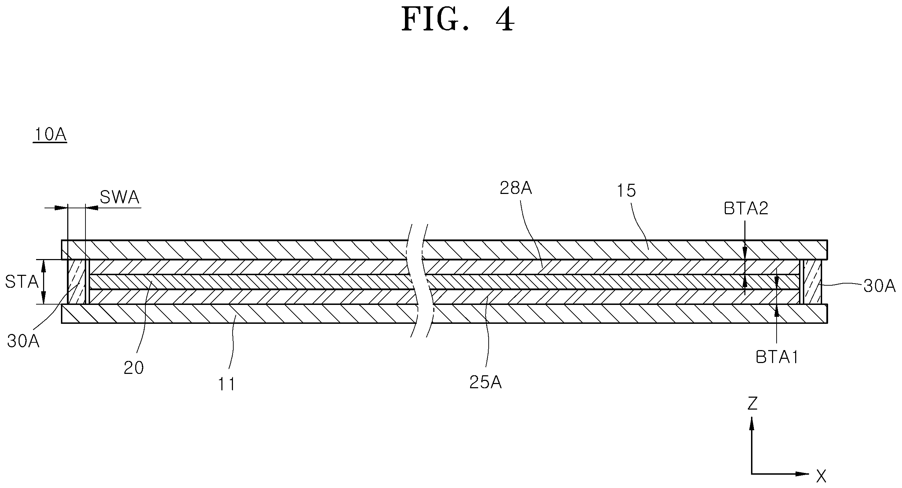

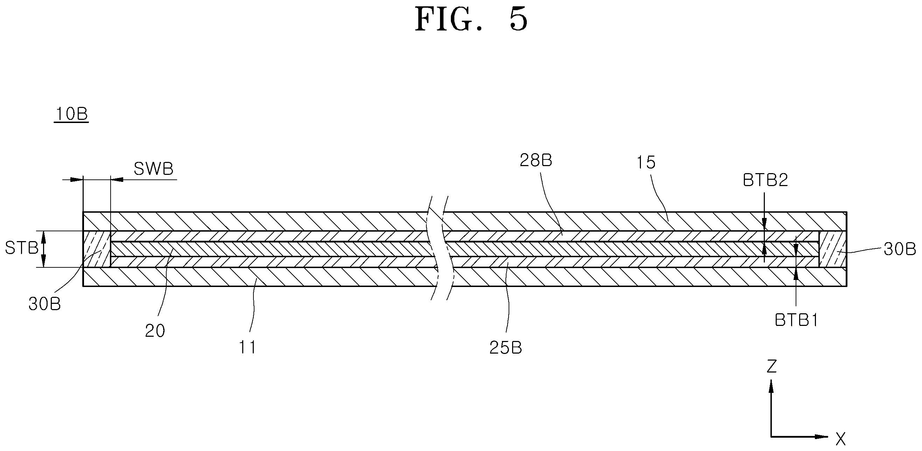

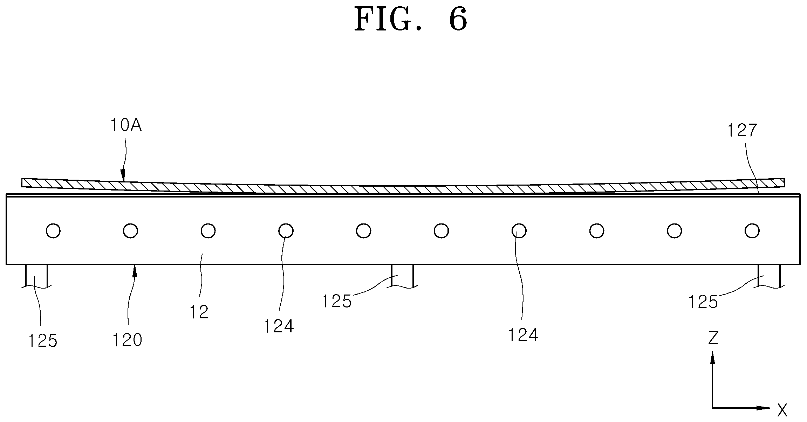

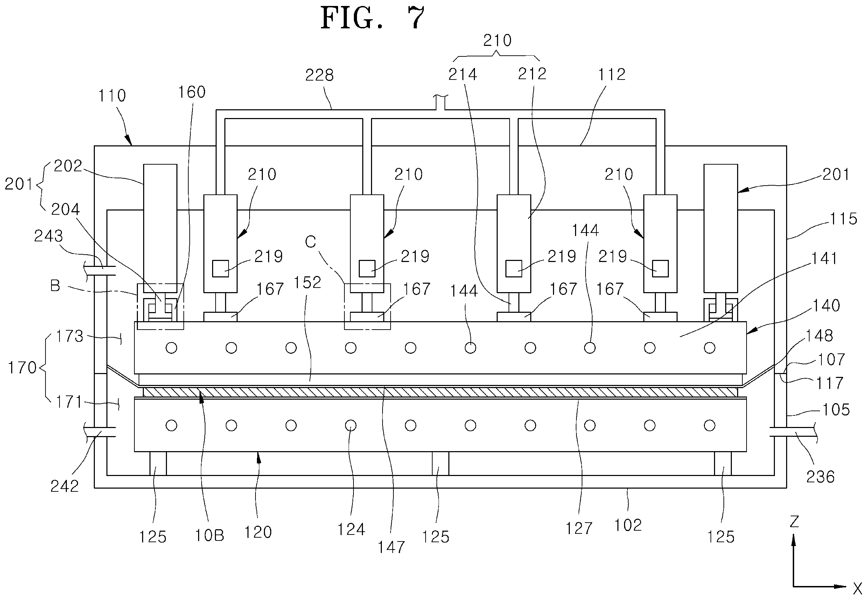

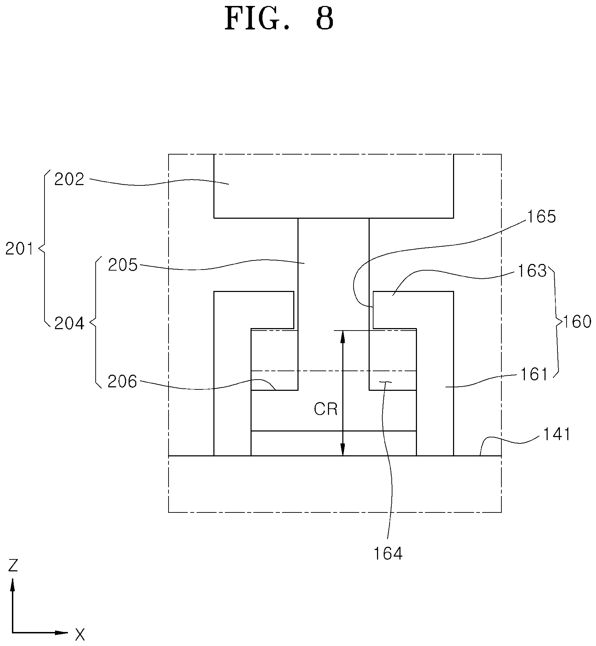

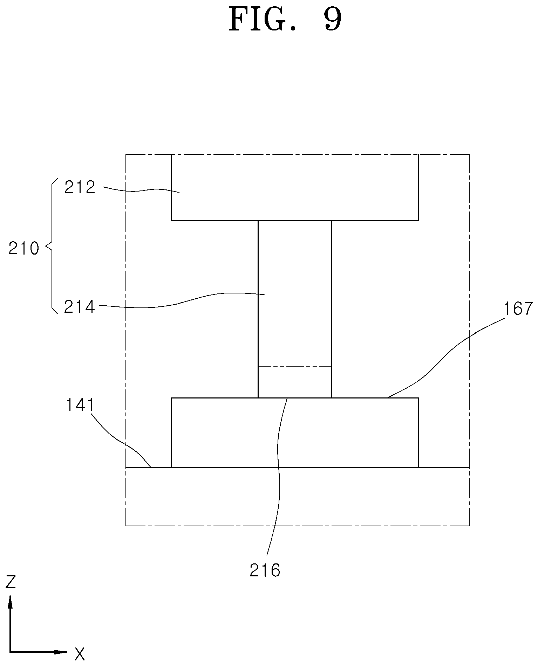

FIG. 1 is a configuration diagram of a solar cell module press apparatus according to an embodiment of the present invention, FIG. 2 is an enlarged view of part A of FIG. 1, FIG. 3 is a plan view of an upper plate in FIG. 1, FIG. 4 is a cross-sectional view of a solar cell module that is not yet loaded onto the solar cell module press apparatus in FIG. 1, FIG. 5 is a cross-sectional view of the solar cell module pressed by the solar cell module press apparatus in FIG. 1, FIG. 6 is a cross-sectional view illustrating a lower plate in FIG. 1 and the solar cell module loaded onto the lower plate, FIG. 7 is a cross-sectional view illustrating the solar cell module press apparatus in FIG. 1 and the solar cell module pressed by the solar cell module press apparatus, FIG. 8 is an enlarged view of part B of FIG. 7, and FIG. 9 is an enlarged view of part C of FIG. 7.

Referring to FIGS. 1 to 9, a solar cell module press apparatus 100 according to an embodiment of the present invention is an apparatus that presses a solar cell module 10A, and includes a first plate 120, a second plate 140, a first cylinder actuator 201, and a second cylinder actuator 210.

The solar cell module 10A may include a first substrate 11, a second substrate 15, a solar cell 20, a first adhesive sheet 25A, a second adhesive sheet 28A, and a seal 30A. The first substrate 11 and the second substrate 15 may be formed of, for example, a light-transmissive material, such as glass. The first substrate 11 and the second substrate 15 may have shapes identical or similar to that of the solar cell module 10A, and may have shapes such as regular polygons or irregular polygons, such as two-dimensional equilateral triangles, squares, and ellipses. For example, the first substrate 11 and the second substrate 15 may have a rectangular planar shape.

The solar cell 20 is interposed between the first substrate 11 and the second substrate 15. A plurality of the solar cells 20 may be provided and arranged in a matrix as a single layer between the first substrate 11 and the second substrate 15.

The first adhesive sheet 25A may be interposed between the first substrate 11 and the solar cell 20, and the second adhesive sheet 28A may be interposed between the second substrate 15 and the solar cell 20. The first adhesive sheet 25A and the second adhesive sheet 28A may be formed of, for example, ethylene vinyl acetate (EVA).

The first adhesive sheet 25A and the second adhesive sheet 28A may have, for example, a rectangular planar shape. As illustrated in FIG. 4, a length in the X-axis direction and a length in a Y-axis direction of the adhesive sheets 25A and 28A and the solar cell 20 may be smaller than a length in the X-axis direction and a length in the Y-axis direction of the corresponding substrates 11 and 15.

The seal 30A may be interposed between the first substrate 11 and the second substrate 15 and disposed to surround the solar cell 20, the first adhesive sheet 25A, and the second adhesive sheet 28A, as illustrated in FIG. 4. The seal 30A may prevent foreign substances such as dust and moisture from penetrating into the solar cell 20 through a space between the first substrate 11 and the second substrate 15. The seal 30A may be formed of, for example, a rubber material such as butyl rubber.

When the unpressed solar cell module 10A is loaded onto the first plate 120 of the solar cell module press apparatus 100 and pressed between the first plate 120 and the second plate 140 under predetermined heating conditions, a thickness BTA1 of the first adhesive sheet 25A may be reduced in a direction parallel to a Z-axis and the first adhesive sheet 25A may be adhered to the first substrate 11 and the solar cell 20.

Further, a thickness BTA2 of the second adhesive sheet 28A may be reduced in the direction parallel to the Z-axis, and the second adhesive sheet 258 may be adhered to the second substrate 15 and the solar cell 20. Further, a thickness STA of the seal 30A may be reduced in the direction parallel to the Z-axis, and a width SWA of the seal 30A may extend in a direction orthogonal to the thickness STA.

In FIG. 5, reference sign "10B" denotes the solar cell module pressed by the solar cell module press apparatus 100. Reference sign "25B" denotes the first adhesive sheet having a reduced thickness, and reference sign "BTB1" denotes the reduced thickness of the first adhesive sheet 25B. Reference sign "28B" denotes the second adhesive sheet with a reduced thickness, and reference sign "BTB2" denotes the reduced thickness of the second adhesive sheet 28B.

Reference sign "30B" denotes a seal that is deformed so that its thickness is reduced and its width is enlarged, "STB" denotes the reduced thickness of the seal 30B, and "SWB" denotes the enlarged width of the seal 30B.

Since the solar cell module 10A is pressed under vacuum conditions, an air layer or bubbles between the first substrate 11 and the second substrate 15 of the solar cell module 10A before pressing are removed after pressing, and there may be no air layer or bubbles between the first substrate 11 and the second substrate 15 of the solar cell module 10B.

For example, in FIGS. 1 to 9, the direction parallel to the Z-axis may be an up-down direction, and a direction parallel to the X-axis and a direction parallel to the Y-axis, which are orthogonal to the Z-axis, may be horizontal directions. The X-axis may be parallel to a longitudinal direction of the solar cell modules 10A and 10B, the first plate 120, and the second plate 140, and the Y-axis, which is orthogonal to the X-axis, may be parallel to a width direction of the solar cell modules 10A and 10B, the first plate 120, and the second plate 140.

The first plate 120 is brought into contact with one side of the solar cell module 10A to support the solar cell module 10A. For example, an upper surface of the first plate 120 may be brought into contact with and support a lower surface of the solar cell module 10A. As a specific example, the lower surface of the first substrate 11 may be supported by the first plate 120.

The second plate 140 is brought into contact with the other side of the solar cell module 10A and moves toward the first plate 120 to press the solar cell module 10A. For example, a lower surface of the second plate 140 may be brought into contact with an upper surface of the solar cell module 10A. In a specific example, an upper surface of the second substrate 15 may be brought into contact with the second plate 140.

For example, the second plate 140 may be positioned above the first plate 120 and move up or down, parallel to the Z-axis with respect to the first plate 120. The solar cell module 10A may be supported by the first plate 120 and the second plate 140 may move down with respect to the first plate 120, so that the solar cell module 10A can be pressed.

The first cylinder actuator 201 moves the second plate 140 toward the first plate 120 until the second plate 140 is brought into contact with the solar cell module 10A. The second cylinder actuator 210 presses the second plate 140 toward the first plate 120 so that the second plate 140 is brought into contact with the solar cell module 10A and then presses the solar cell module 10A. The solar cell module press apparatus 100 according to the embodiment of the present invention may include a plurality of the first cylinder actuators 201 and a plurality of the second cylinder actuators 210.

The first cylinder actuator 201 may support the second plate 140 and move the second plate 140 toward the first plate 120 and away from the first plate 120. For example, the first cylinder actuator 201 may move the second plate 140 downward, parallel to a negative (-) Z-axis direction, to move the second plate 140 toward the first plate 120, and move the second plate 140 upward, parallel to a positive (+) Z-axis direction, to move the second plate 140 away from the first plate 120.

A method of manufacturing the solar cell module 10B may include a pre-assembly operation, a pressing operation, a curing operation, and a cooling operation. The pre-assembly operation is an operation of manufacturing the non-pressed solar cell module 10A in a pre-assembled state by laminating the first substrate 11, the first adhesive sheet 25A, the solar cell 20, the second adhesive sheet 28A, and the second substrate 15. The pre-assembly operation may include an operation of interposing the seal 30A surrounding the first adhesive sheet 25A, the solar cell 20, and the second adhesive sheet 28A between the first substrate 11 and the second substrate 15. The solar cell module 10A illustrated in FIG. 4 may be an example of a pre-assembled solar cell module manufactured in the pre-assembly operation.

The pressing operation is an operation of loading the pre-assembled solar cell module 10A onto the solar cell module press apparatus 100 and pressing the pre-assembled solar cell module 10A. The solar cell module 10B illustrated in FIG. 5 may be an example of the solar cell module 10B that is pressed in the pressing operation.

The fluidity of the first adhesive sheet 25B and the second adhesive sheet 28B may increase due to heating and pressing in the pressing operation, but the first adhesive sheet 25B and the second adhesive sheet 28B do not leak to the outside of the solar cell module 10B since a space between an outer periphery of the first substrate 11 and an outer periphery of the second substrate 15 is sealed by the seal 30B, and the seal 30B may also prevent the first adhesive sheet 25B and the second adhesive sheet 28B from leaking to the outside of the solar cell module 10B.

The curing operation is an operation of heating the solar cell module 10B to a predetermined temperature so that the first adhesive sheet 25A and the second adhesive sheet 25B are cured again in a state in which the solar cell 20 and the first substrate 11 are adhered by the first adhesive sheet 25A and the solar cell 20 and the second substrate 15 are adhered by the second adhesive sheet 25B in the pressing operation. A heating temperature of the solar cell module 10B in the curing operation may be, for example, 140 °C. The cooling operation is an operation of cooling the solar cell module 10B to room temperature after the curing operation.

The solar cell module press apparatus 100 may further include a first chamber 101, a second chamber 110, and a vacuum pump 232. The first chamber 101 supports the first plate 120. The second chamber 110 supports the second plate 140 and the actuator. For example, the second chamber 110 may be located above the first chamber 101.

The second chamber 110 may move into close contact with the first chamber 101 and away from the first chamber 101. For example, when the second chamber 110 moves down in the negative (-) Z-axis direction, the second chamber 110 may move toward the first chamber 101 and come into close contact with the first chamber 101. On the other hand, when the second chamber 110 is in close contact with the first chamber 101, the second chamber 110 may move up in the positive (+) Z-axis direction and may be separated from the first chamber 101.

When the second chamber 110 is separated from the first chamber 101 and the second plate 140 is separated from the first plate 120, the solar cell module 10A in a pre-assembled state may be loaded onto the first plate 120, or the pressed solar cell module 10B may be unloaded from the first plate 120 and discharged to the outside of the solar cell module press apparatus 100.

The first chamber 101 may include a first base part 102 and a first side wall part 105 protruding from the first base part 102 toward the second chamber 110. The solar cell module press apparatus 100 may further include a plurality of supports 125 interposed between the first base part 102 and the first plate 120 and supporting the first plate 120 spaced apart from the first base part 102. The first chamber 101 and the first plate 120 may not move in the Z-axis direction.

The second chamber 110 may include a second base part 112 and a second side wall part 115 protruding from the second base part 112 toward the first chamber 101. When the second chamber 110 moves toward the first chamber 101, an end 117 of the second side wall part 115 may be brought into close contact with an end 107 of the first side wall part 105. In this case, the second chamber 110 may be brought into close contact with the first chamber 101.

When the second chamber 110 is brought into close contact with the first chamber 101, an internal space 170 accommodating the first plate 120 and the second plate 140 may be defined. The internal space 170 may include a first space 171 defined by the first base part 102 and the first side wall part 105, and a second space 173 defined by the second base part 112 and the second side wall part 115.

The vacuum pump 232 discharges air from the internal space 170 to the outside of the first chamber 101 and the second chamber 110 so that a vacuum pressure is formed in the internal space 170. The vacuum pump 232 may be connected to the internal space 170 by a vacuum line 236 to enable air flow. For example, the vacuum line 236 may pass through the first side wall part 105. A valve 234 that selectively blocks a flow of air may be installed in the vacuum line 236.

The solar cell module press apparatus 100 may further include an air flow line 240 that connects the first space 171 to the second space 173 to enable air flow. For example, one side 242 of the air flow line 240 may pass through the first side wall part 105, and the other side 243 of the air flow line 240 may pass through the second side wall part 115.

Therefore, even when the vacuum line 236 is directly connected to the first space 171 and not directly connected to the second space 173, air in the second space 173 may move to the first space 171 through the air flow line 240 and may be discharged out of the first chamber 101 through the vacuum line 236, so that the internal space 170 can reach a predetermined vacuum pressure within a short period of time after the vacuum pump 232 starts operating.

At least one of the first plate 120 and the second plate 140 may include heaters 124 and 144 that heat the solar cell module 10A. For example, the first plate 120 may include a plurality of first heaters 124 spaced apart at regular intervals therein, and the second plate 140 may include a plurality of second heaters 144 spaced apart at regular intervals therein. The first heaters 124 and the second heaters 144 may generate heat according to supplied electric energy.

The first heaters 124 and the second heaters 144 may heat the solar cell module 10A interposed between the first plate 120 and the second plate 140 to a predetermined temperature. For example, the predetermined temperature may be 140 °C. Since the solar cell module 10A is pressed and heated between the first plate 120 and the second plate 140, the fluidity of the adhesive sheets 25A and 28A can be improved and damage to the substrates 11 and 15 can be prevented.

The first plate 120 may include a first body 121 and a first friction mitigation film 127. The first heaters 124 may be inserted into and installed in the first body 121. The first friction mitigation film 127 may cover one side of the first body 121 facing the solar cell module 10A to reduce friction when the first plate 120 is brought into contact with the solar cell module 10A.

For example, the first friction mitigation film 127 may cover an upper surface of the first body 121. For example, the first friction mitigation film 127 may be attached to the upper surface of the first body 121 or may be laminated on the upper surface of the first body 121 by coating and curing.

The second plate 140 may include a second body 141, a second friction mitigation film 147, and an elastic pad 152. A second heater 144 may be inserted into and installed in the second body 141.

The second friction mitigation film 147 may cover one side of the second body 141 facing the solar cell module 10A to reduce friction when the second plate 140 is brought into contact with the solar cell module 10A. For example, the second friction mitigation film 147 may cover a lower surface of the second body 141.

When the first friction mitigation film 127 and the second friction mitigation film 147 are not included, static electricity due to friction may be generated in the solar cell module 10A when the solar cell module 10A is placed on the first plate 120 or when the solar cell module 10A is pressed toward the first plate 120 by the second plate 140, which may increase a defect rate of the completed solar cell module 10B.

The first friction mitigation film 127 and the second friction mitigation film 147 may include, for example, polytetrafluoroethylene (PTFE). In other words, the first friction mitigation film 127 and the second friction mitigation film 147 may be formed of a PTFE material.

The elastic pad 152 may be interposed between the one side of the second body 141, for example, the lower surface of the second body 141, and the second friction mitigation film 147. The elastic pad 152 may overlap the solar cell module 10A in a direction parallel to the Z-axis, that is, the up-down direction.

The elastic pad 152 evenly distributes the pressing force over the entire area of the solar cell module 10A when the second plate 140 presses the solar cell module 10A. When there is no elastic pad 152, the pressing force is concentrated on a part of an entire flat area of the solar cell module 10A, which may increase a failure rate of the completed solar cell module 10B.

The elastic pad 152 may include, for example, silicone rubber. A thickness of the elastic pad 152 may be larger than the thickness of the second friction mitigation film 147. The second friction mitigation film 147 may be supported by the second chamber 110 instead of being supported by the second body 141. For example, an outer peripheral end 148 of the second friction mitigation film 147 may be coupled to and supported by the second side wall part 115 of the second chamber 110.

The second friction mitigation film 147 may be suspended in the second chamber 110 to cover the lower surface of the second body 141 and support the elastic pad 152 so that the elastic pad 152 is in close contact with the lower surface of the second body 141. Further, the second friction mitigation film 147 may include a recessed seating groove 149 for seating the elastic pad 152.

With this configuration, even when the second plate 140 is slightly tilted while being moved down, the elastic pad 152 and the second friction mitigation film 147 may simultaneously come into contact with and press the entire area of the solar cell module 10A down. Further, the elastic pad 152 may be prevented from deviating from a correct location determined with respect to the second friction mitigation film 147.

The first cylinder actuator 201 includes a first cylinder body 202 and a first cylinder rod 204. The first cylinder body 202 is fixed to the second chamber 110. For example, the first cylinder body 202 may be fixed to and supported by the second base part 112.

For example, the first cylinder actuator 201 may be a so-called pneumatic cylinder that operates according to pneumatic pressure. The solar cell module press apparatus 100 may further include a pneumatic pump (not shown) that provides pneumatic pressure to the first cylinder body 202.

The first cylinder rod 204 may include one end inserted into the first cylinder body 202, a flange part 206 located outside the first cylinder body 202, and a neck part 205 that connects the one end to the flange part 206. A size of a diameter of the neck part 205 is smaller than that of the flange part 206. For example, the one end of the first cylinder rod 204 may be an upper end, and the flange part 206 may be a lower end.

The second plate 140 may further include a cylinder rod holder 160 that is fixed to the second body 141 and in which a flange part space 164 into which the flange part 206 is inserted is formed. For example, the cylinder rod holder 160 may be coupled to and supported by an upper surface of the second body 141.

The cylinder rod holder 160 may include a stopper part 163 and a holder wall part 161. The stopper part 163 may block the flange part 206 to prevent the flange part 206 from coming off from the flange part space 164. The stopper part 163 may be spaced apart from the upper surface of the second body 141. A through hole 165 with an inner diameter that allows the neck part 205 to pass through the through hole 165 but prevents the flange part 206 from passing through the through hole 165 may be formed at a center of the stopper part 163.

The holder wall part 161 may be bent at an outer periphery of the stopper part 163, extend toward the second body 141, and be coupled to the second body 141. The flange part space 164 may be defined by the holder wall part 161 and the stopper part 163.

The flange part space 164 may have a clearance CR that allows the flange part 206 to move parallel to a longitudinal direction of the first cylinder rod 204, that is, parallel to the Z-axis.

The second cylinder actuator 210 includes a second cylinder body 212 and a second cylinder rod 214. The second cylinder body 212 is fixed to the second chamber 110. For example, the second cylinder body 212 may be fixed to and supported by the second base part 112.

The second cylinder rod 214 includes one end that is inserted into the second cylinder body 212, and another end 216 that protrudes to the outside of the second cylinder body 212, is brought into close contact with the second plate 140 in a state in which the other end 216 is separated from the second plate 140, and pushes the second plate 140 away from the second cylinder body 212. For example, the one end of the second cylinder body 212 may be an upper end, and the other end of the second cylinder body 212 may be a lower end.

The second plate 140 may further include a collision plate 167 coupled and fixed to the upper surface of the second body 141 and positioned to be aligned with the corresponding second cylinder body 212 in the up-down direction. The collision plate 167 is positioned to be aligned with the second cylinder actuator 210. When the second cylinder actuator 210 presses the second plate 140 toward the first plate 120, the second cylinder actuator 210 may collide with the collision plate 167.

For example, the second cylinder actuator 210 may be a so-called hydraulic cylinder that operates according to hydraulic pressure. The solar cell module press apparatus 100 may further include a hydraulic pump 222, a hydraulic line 228, a regulator 224, and a solenoid valve 226.

The hydraulic pump 222 generates hydraulic pressure that is provided to the second cylinder body 212. The hydraulic pressure generated by the hydraulic pump 222 may be supplied to the second cylinder body 212 through the hydraulic line 228. The regulator 224 may finely adjust the hydraulic pressure supplied to the second cylinder actuator 210. The solenoid valve 226 selectively opens or closes the hydraulic line 228.

The solar cell module press apparatus 100 may further include a pressure sensor 219 that measures a level of the hydraulic pressure supplied to the second cylinder actuator 210. The pressure sensor 219 may be installed, for example, in the second cylinder body 212 or the hydraulic line 228.

The regulator 224 may adjust the hydraulic pressure supplied to the second cylinder actuator 210 based on the level of the hydraulic pressure measured by the pressure sensor 219. Therefore, an error between an actual force with which a plurality of second cylinder actuators 210 press the second plate 140 and a predetermined reference pressing force can be minimized.

As illustrated in FIG. 3, distances OD1 and OD2 from a center CP of a planar shape of the second plate 140 to the second cylinder actuators 210 may be smaller than a distance AD from the center CP of the planar shape of the second plate 140 to the first cylinder actuator 201.

When the plurality of second cylinder actuators 210 and a plurality of first cylinder actuators 201 are provided, the distance OD1 to the second cylinder actuator 210 that is farthest from the center CP among the plurality of second cylinder actuators 210 may be smaller than the distance AD to the first cylinder actuator 201 that is closest to the center CP among the plurality of first cylinder actuators 201.

For example, the plurality of second cylinder actuators 210 may be disposed in a central portion relatively close to the center CP in a planar area of the second plate 140, and the plurality of first cylinder actuators 201 may be disposed in an outer portion relatively far from the center CP and close to outer corners.

In the central portion, the plurality of second cylinder actuators 210 may be disposed with a uniform distribution without bias. Accordingly, the plurality of first cylinder actuators 201 may stably support the second plate 140 without tilting and move the second plate 140 up or down. Further, the pressing force may be evenly applied to an entire surface of the solar cell module 10A by the plurality of second cylinder actuators 210.

Referring to FIG. 3, for example, the planar shape of the second plate 140 is a rectangle having four corners 143, and the solar cell module press apparatus 100 includes four first cylinder actuators 201 and eight second cylinder actuators 210.

The four first cylinder actuators 201 are disposed closer to the four corners 143 than to the center CP of the second plate 140, and the eight second cylinder actuators 210 are disposed closer to the center CP than to locations of the four first cylinder actuators 201.

After the solar cell module 10A is loaded onto the first plate 120, the second chamber 110 may move down to be brought into close contact with the first chamber 101, and the vacuum pump 232 may operate to form a vacuum atmosphere in the internal space 170. The plurality of first cylinder actuators 201 and the plurality of second cylinder actuators 210 supported by the second chamber 110 may also move down together with the second chamber 110.

Even when the second chamber 110 moves down to be brought into close contact with the first chamber 101, the second plate 140 is spaced apart not to be brought into contact with the solar cell module 10A. In the next operation, when the first cylinder rod 204 of each of the first cylinder actuators 201 protrudes from the first cylinder body 202 and the flange part 206 moves down, the second plate 140 may move down toward the first plate 120 with the stopper part 163 supported by the flange part 206, as indicated by a two-dot chain line in FIG. 8.

When the second plate 140 is brought into contact with the solar cell module 10A supported by the first plate 120 and then the first cylinder rod 204 further protrudes from the first cylinder body 202, the stopper part 163 no longer moves down and the flange part 206 may move further down to the upper surface of the second body 141 in the flange part space 164.

Accordingly, as indicated by a solid line in FIG. 8, the flange part 206 may be spaced apart from the stopper part 163. A maximum distance by which the flange part 206 can move down from the flange part space 164 may be equal to a size of the clearance CR.

When the solar cell module 10A is not flat in a horizontal direction and is bent so that its outer periphery is raised as illustrated in FIG. 6, the solar cell module 10A can be pressed by a self-weight of the second plate 140 rather than a pressing force of the first cylinder actuator 201 and flattened or its bending can be mitigated.

Thus, when the solenoid valve 226 is opened and hydraulic pressure is supplied to the second cylinder body 212 in a state in which the second plate 140 is in contact with the solar cell module 10A, the second cylinder rod 214 moves down toward the second plate 140 and the lower end 216 of the second cylinder rod 214 collides with the collision plate 167.

When the second cylinder rod 214 continues to move down even after the lower end 216 of the second cylinder rod 214 collides with the collision plate 167, the second plate 140 moves toward the first plate 120 due to hydraulic pressure to thereby press the solar cell module 10A. The pressing force with which the plurality of second cylinder actuators 210 press the solar cell module 10A may be higher than the pressing force with which the solar cell module 10A is pressed by the self-weight of the second plate 140.

When the hydraulic pressure is discharged from the second cylinder body 212 in a state in which the lower end 216 of the second cylinder rod 214 is in contact with the collision plate 167 after the pressing of the solar cell module 10B is completed, the second cylinder rod 214 moves up and is spaced apart from the collision plate 167.

Thus, the second plate 140 is moved down toward the first plate 120 by the second cylinder actuator 210, but is not moved up away from the first plate 120 by the second cylinder actuator 210.

When the first cylinder rod 204 returns to its original location with respect to the first cylinder body 202 after the second cylinder rod 214 moves up, in other words, when the first cylinder rod 204 moves to be inserted into the first cylinder body 202, the flange part 206 is brought into contact with and supports the stopper part 163 again and lifts the stopper part 163 up, so that the second plate 140 can be spaced apart from the solar cell module 10B.

Next, the second chamber 110 moves up relative to the first chamber 101, and the solar cell module 10B may be extracted to the outside from between the first plate 120 and the second plate 140.

As described above, a pressing force of the second cylinder actuator 210 may not be applied to the second plate 140 until the second plate 140 is brought into contact with the solar cell module 10A, and a pressing force of the first cylinder actuator 201 may not be applied to the second plate 140 after the second plate 140 is brought into contact with the solar cell module 10A.

According to the present invention, it is possible to press the solar cell module with uniform pressure over the entire area of the solar cell module. Therefore, it is possible to improve the adhesion quality between the substrate and the solar cell of the solar cell module, thereby improving the yield and durability of the solar cell module.

According to the present invention, it is possible to prevent a corner portion of the solar cell module from being damaged during pressing of the solar cell module, thereby improving the yield and durability of the solar cell module.

The present invention has been described with reference to the embodiments shown in the drawings, but this is merely an example, and it will be understood by those skilled in the art that various modifications and other equivalent embodiments can be made from the embodiments. Therefore, the true technical protection scope of the present invention should be determined from the claims below.

## Claims

1. A solar cell module press apparatus comprising:
a first plate configured to be brought into contact with one side of a solar cell module to support the solar cell module;
a second plate configured to be brought into contact with the other side of the solar cell module and move toward the first plate to press the solar cell module;
a first cylinder actuator configured to move the second plate toward the first plate until the second plate is brought into contact with the solar cell module; and
a second cylinder actuator configured to press the second plate toward the first plate so that the solar cell module is pressed after the second plate is brought into contact with the solar cell module.

2. The solar cell module press apparatus as claimed in claim 1, further comprising:
a first chamber configured to support the first plate; and
a second chamber configured to support the second plate, the first cylinder actuator, and the second cylinder actuator, and move into close contact with the first chamber and away from the first chamber,
wherein, when the second chamber is brought into close contact with the first chamber, an internal space accommodating the first plate and the second plate is defined.

3. The solar cell module press apparatus as claimed in claim 2, wherein
the first chamber includes a first base part, and a first side wall part protruding from the first base part toward the second chamber,
the second chamber includes a second base part, and a second side wall part protruding from the second base part toward the first chamber, and
when the second side wall part is brought into close contact with the first side wall part, the second chamber is brought into close contact with the first chamber.

4. The solar cell module press apparatus as claimed in claim 2, wherein the first plate includes
a first body, and
a first friction mitigation film configured to cover one side of the first body facing the solar cell module to reduce friction when the first plate is brought into contact with the solar cell module.

5. The solar cell module press apparatus as claimed in claim 2, wherein the second plate further includes
a second body; and
a second friction mitigation film configured to cover one side of the second body facing the solar cell module to reduce friction when the second plate is brought into contact with the solar cell module.

6. The solar cell module press apparatus as claimed in claim 5, wherein the second plate further includes an elastic pad overlapping the solar cell module between the one side of the second body and the second friction mitigation film.

7. The solar cell module press apparatus as claimed in claim 6, wherein the elastic pad includes silicone rubber.

8. The solar cell module press apparatus as claimed in claim 6, wherein the second friction mitigation film includes a recessed seating groove for seating the elastic pad.

9. The solar cell module press apparatus as claimed in claim 6, wherein the second friction mitigation film is supported by the second chamber.

10. The solar cell module press apparatus as claimed in claim 4 or 5, wherein the friction mitigation film includes polytetrafluoroethylene (PTFE).

11. The solar cell module press apparatus as claimed in claim 2, wherein the second plate includes a collision plate that is positioned to be aligned with the second cylinder actuator and with which the second cylinder actuator collides when the second cylinder actuator presses the second plate toward the first plate.

12. The solar cell module press apparatus as claimed in claim 2, further comprising a vacuum pump configured to discharge air from the internal space to the outside of the first chamber and the second chamber so that a vacuum pressure is formed in the internal space.

13. The solar cell module press apparatus as claimed in claim 2, wherein
the first chamber includes a first base part, and a first side wall part protruding from the first base part toward the second chamber,
the second chamber includes a second base part, and a second side wall part protruding from the second base part toward the first chamber,
the internal space includes a first space defined by the first base part and the first side wall part, and a second space defined by the second base part and the second side wall part, and
the solar cell module press apparatus further includes an air flow line configured to connect the first space to the second space to enable air flow.

14. The solar cell module press apparatus as claimed in claim 1, wherein at least one of the first plate and the second plate includes a heater configured to heat the solar cell module.

15. The solar cell module press apparatus as claimed in claim 1, wherein
a pressing force of the second cylinder actuator is not applied to the second plate until the second plate is brought into contact with the solar cell module, and
a pressing force of the first cylinder actuator is not applied to the second plate after the second plate is brought into contact with the solar cell module.
